# EUROPEAN PATENT APPLICATION

(11) **EP 3 270 543 A1**
(43) Date of publication of application: **17.01.2018**
(21) Application number: 17176875.7
(22) Date of filing: 20.06.2017
(51) Int. Cl.: H04L 12/24, H04L 12/26, G05B 19/04

(54) **INFORMATION PROCESSING APPARATUS, INFORMATION PROCESSING PROGRAM, AND INFORMATION PROCESSING METHOD**

(30) Priority: 12.07.2016 JP 2016137457
(71) Applicant: Omron Corporation, Kyoto-shi, Kyoto 600-8530 (JP)
(72) Inventor: UEDA, Takamasa, Kyoto-shi, Kyoto 600-8530 (JP); FUJIWARA, Kiyotaka, Kyoto-shi, Kyoto 600-8530 (JP); MATSUI, Asahi, Kyoto-shi, Kyoto 600-8530 (JP)
(74) Representative: Horn Kleimann Waitzhofer Patentanwälte PartG mbB

(57) **Abstract**

The cause of an abnormality is identified easily to allow quicker recovery from it. An information processing apparatus is connected to a control system including a first network allowing constant period communication connected to a first node for managing the constant period communication and to one or more second nodes other than the first node. The apparatus includes a first obtaining unit that obtains, from the first node, first status information indicating a communicating status of each second node in the first network, a second obtaining unit that obtains second status information indicating an operating status of each second node, a third obtaining unit that obtains third status information indicating an operating status of a second node that includes a predetermined type device, and an output unit that outputs, for each second node, the first status information, the corresponding second status information, and the corresponding third status information in line.

## Description

### FIELD

The disclosure relates to an information processing apparatus, an information processing program, and an information processing method for a networked control system.

### BACKGROUND

The recent advancement of information and communication technology (ICT) allows various apparatuses used at manufacturing sites to have higher functionality and intelligence. More specifically, a system in practical use includes controllers such as a programmable controller (PLC), input-output (I/O) devices such as a safety controller, a sensor, and a relay, and actuators such as an inverter and a motor driver, which are interconnected and integrated with a network.

For example, Japanese Unexamined Patent Application Publication No. 2012-194631 (Patent Literature 1) describes a network system including a master device and slave devices.

### CITATION LIST

### PATENT LITERATURE

Patent Literature 1: Japanese Unexamined Patent Application Publication No. 2012-194631

### SUMMARY

### TECHNICAL PROBLEM

In a networked control system, the network, and the apparatuses and units connected to the network are linked with one another. An abnormality in the system can affect a larger portion of the system. Thus, identifying and removing the cause of an abnormality can be complex and complicated. A technique is to be developed for easily identifying the cause of an abnormality to allow quicker recovery from the abnormality.

### SOLUTION TO PROBLEM

A first aspect of the present invention provides an information processing apparatus that is connected to a control system including a first network that allows constant period communication. The first network is connected to a first node for managing the constant period communication and to one or more second nodes other than the first node. The information processing apparatus includes a first obtaining unit that obtains, from the first node, first status information indicating a communicating status of each of the second nodes in the first network, a second obtaining unit that obtains second status information indicating an operating status of each of the second nodes, a third obtaining unit that obtains third status information indicating an operating status of one of the second nodes that includes a device of a predetermined type, and an output unit that outputs, for each of the second nodes, the first status information, the corresponding second status information, and the corresponding third status information that are arranged in line.

In some embodiments, the output unit changes a display mode of at least one of the first status information, the second status information, or the third status information depending on the corresponding status.

In some embodiments, in response to selection of third status information, the output unit outputs more detailed information than previous output of the third status information about the corresponding selected device.

In some embodiments, when the selected device includes one or more input-output units and an arithmetic unit for transmitting and receiving intended data between the one or more input-output units and the arithmetic unit, the output unit outputs, as the detailed information, a list of statuses of the one or more input-output units managed by the arithmetic unit.

In some embodiments, in response to selection of one of the listed input-output units, the output unit outputs an input status or an output status of the selected input-output unit.

In some embodiments, when the selected device includes one or more input-output units for collecting and outputting data to be used in another arithmetic unit through the first network, the output unit outputs an input status or an output status of each of the input-output units as the detailed information.

In some embodiments, the output unit outputs the third status information together with information indicating the type of the corresponding device with an operating status indicated by the third status information.

In some embodiments, one of the second nodes includes an input-output unit connected to a second network. The information processing apparatus further includes a fourth obtaining unit that obtains fourth status information indicating a status of the input-output unit connected to the second network. The output unit outputs the corresponding fourth status information, the first status information, the corresponding second status information, and the corresponding third status information in a manner arranged in line.

Another aspect of the present invention provides an information processing program executable by a computer that is connected to a control system including a first network that allows constant period communication. The first network is connected to a first node for managing the constant period communication and to one or more second nodes other than the first node. The information processing program enables the computer to implement obtaining, from the first node, first status information indicating a communicating status of each of the second nodes in the first network, obtaining second status information indicating an operating status of each of the second nodes, obtaining third status information indicating an operating status of one of the second nodes that includes a device of a predetermined type, and outputting, for each of the second nodes, the first status information, the corresponding second status information, and the corresponding third status information in a manner arranged in line.

Another aspect of the present invention provides an information processing method implemented by an apparatus that is connected to a control system including a first network that allows constant period communication. The first network is connected to a first node for managing the constant period communication and to one or more second nodes other than the first node. The information processing method includes obtaining, from the first node, first status information indicating a communicating status of each of the second nodes in the first network, obtaining second status information indicating an operating status of each of the second nodes, obtaining third status information indicating an operating status of one of the second nodes that includes a device of a predetermined type, and outputting, for each of the second nodes, the first status information, the corresponding second status information, and the corresponding third status information in a manner arranged in line.

Another aspect of the present invention provides an information processing apparatus that is connected to a control system including a first network that allows constant period communication. The first network is connected to a first node for managing the constant period communication and to one or more second nodes other than the first node. The apparatus includes an obtaining unit that obtains first abnormality information indicating an abnormality caused in the first network and second abnormality information indicating an abnormality caused in each of the second nodes, a first output unit that outputs, for each of the second nodes, a communicating status and an operating status of the second node in the first network, and a second output unit that extracts, in response to selection of the output communicating status of one of the second nodes, the abnormality caused in the selected second node from the first abnormality information and outputs information about the extracted abnormality, and in response to selection of the output operating status of one of the second nodes, extracts and outputs the second abnormality information corresponding to the selected second node.

In some embodiments, the first output unit outputs the operating status of one of the second nodes that includes a device of a predetermined type. When the operating status of the device of the predetermined type is output, in response to a user operation, the second output unit extracts, from the second abnormality information, an abnormality caused in the device having the output operating status and in a device connected to the device, and outputs information about the extracted abnormality.

In some embodiments, the device of the predetermined type includes an arithmetic unit for transmitting and receiving intended data between one or more input-output units and the arithmetic unit.

In some embodiments, when an input status or an output status of the input-output units mounted on the arithmetic unit is output, in response to selection of one of the input-output units, the second output unit extracts, from the second abnormality information, an abnormality caused in the input-output units having the output statuses, and outputs information about the extracted abnormality.

In some embodiments, the second output unit allows selective output of the first abnormality information in response to a user operation.

Another aspect of the present invention provides an information processing program executable by a computer that is connected to a control system including a first network that allows constant period communication. The first network is connected to a first node for managing the constant period communication and to one or more second nodes other than the first node. The information processing program enables the computer to implement obtaining first abnormality information indicating an abnormality caused in the first network and second abnormality information indicating an abnormality caused in each of the second nodes, outputting, for each of the second nodes, a communicating status and an operating status of the second node in the first network, and extracting, in response to selection of the output communicating status of one of the second nodes, the abnormality caused in the selected second node from the first abnormality information and outputting information about the extracted abnormality, and in response to selection of the output operating status of one of the second nodes, extracting and outputting the second abnormality information corresponding to the selected second node.

Another aspect of the present invention provides an information processing method implemented by an apparatus that is connected to a control system including a first network that allows constant period communication. The first network is connected to a first node for managing the constant period communication and to one or more second nodes other than the first node. The information processing method includes obtaining first abnormality information indicating an abnormality caused in the first network and second abnormality information indicating an abnormality caused in each of the second nodes, outputting, for each of the second nodes, a communicating status and an operating status of the second node in the first network, and extracting, in response to selection of the output communicating status of one of the second nodes, the abnormality caused in the selected second node from the first abnormality information and outputting information about the extracted abnormality, and in response to selection of the output operating status of one of the second nodes, extracting and outputting the second abnormality information corresponding to the selected second node.

### ADVANTAGEOUS EFFECTS

The embodiments of the present invention allow easier identification of the cause of an abnormality.

### BRIEF DESCRIPTION OF THE DRAWINGS

Fig. 1 is a schematic diagram showing the configuration of a control system according to one embodiment.
Fig. 2 is a block diagram showing the hardware configuration of a programmable terminal in the control system according to the embodiment.
Fig. 3 is a block diagram showing the hardware configuration of a PLC in the control system according to the embodiment.
Fig. 4 is a schematic diagram describing an information output function according to the embodiment.
Fig. 5 shows a device list display screen provided in the control system according to the embodiment.
Fig. 6 shows a device map display screen provided in the control system according to the embodiment.
Fig. 7 shows a safety controller status display screen provided in the control system according to the embodiment.
Fig. 8 shows a safety I/O unit status display screen provided in the control system according to the embodiment.
Fig. 9 shows a remote I/O device status display screen provided in the control system according to the embodiment.
Figs. 10A and 10B show abnormality message display screens provided in the control system according to the embodiment.
Fig. 11 shows the transitions of user interface screens provided in the control system according to the embodiment.
Fig. 12 shows another device map display screen provided in the control system according to the embodiment.
Fig. 13 shows a location display screen provided in the control system according to the embodiment.
Fig. 14 is a schematic diagram showing another configuration of the control system according to the embodiment.
Fig. 15 shows another device map display screen provided in the control system according to the embodiment.
Fig. 16 is a sequence diagram showing a procedure for providing a user interface screen in the control system according to the embodiment.

### DETAILED DESCRIPTION

Embodiments of the present invention will now be described with reference to the drawings. The same or corresponding components in the figures are given the same reference numerals, and will not be described redundantly.

### A. Configuration of Control System

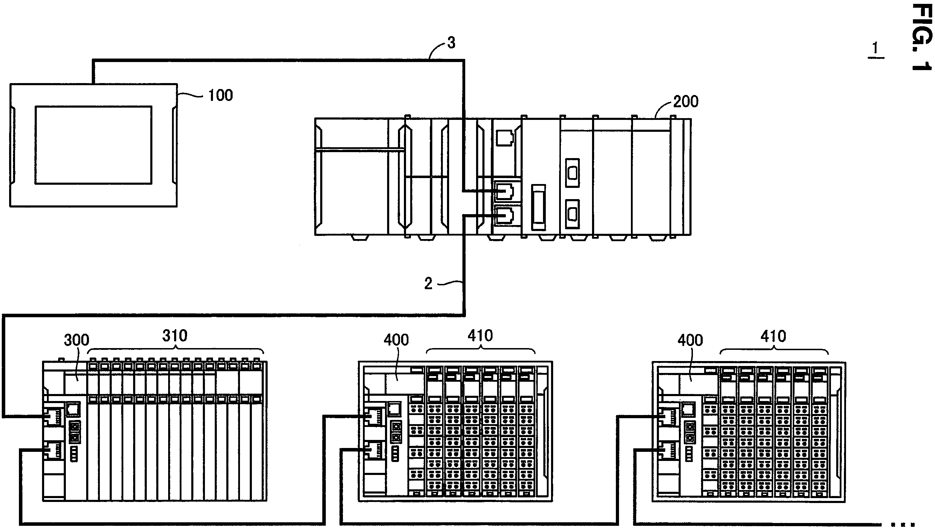

The configuration of a control system according to one embodiment will now be described. Fig. 1 is a schematic diagram showing the configuration of the control system according to the present embodiment. Referring now to Fig. 1, the control system 1 includes a network 2 that allows constant period communication. The control system 1 includes multiple devices that are connected to the network 2. The network 2 allowing constant period communication equates to allocating time to communication between nodes in the network 2. Typically, communication data is updated at predetermined intervals. The network 2 that allows constant period communication may comply with a protocol such as EtherCAT (registered trademark), EtherNet/IP (registered trademark), DeviceNet (registered trademark), or CompoNet (registered trademark). Although the control system 1 shown in Fig. 1 has the single network 2 for ease of explanation, the control system 1 may use multiple networks compliant with the same or different protocols.

The control system 1 shown in Fig. 1 includes a programmable logic controller (PLC) 200, a remote input-output (I/O) device 300, and a safety controller 400, which are connected to the network 2. Each device corresponds to a node connected to the network 2, and functions as a communication device for data transfer through the network 2. In the configuration shown in Fig. 1, the PLC 200 is a node for managing the constant period communication in the network 2. The node for managing the constant period communication (PLC 200 in Fig. 1) is also referred to as a master node, and the other nodes as slave nodes based on the assigned individual functions in the network 2.

The PLC 200 is an example of a controller, and controls a target, such as equipment or a machine, by executing a user program. The remote I/O device 300 collects information indicating the status of the control target such as the equipment or the machine, and transfers the information to the PLC 200 and the safety controller 400 as input data. The remote I/O device 300 also outputs a control output (or output data) computed by the PLC 200 or the safety controller 400 as an instruction to the control target such as the equipment or the machine. The safety controller 400 implements the safety function for the control target and the associated machines and equipment by executing a safety program.

The PLC 200, the remote I/O device 300, and the safety controller 400 may each have an input-output (I/O) unit mounted on it. Typically, the I/O unit is mounted on each device with an internal bus (not shown in Fig. 1). In the configuration shown in Fig. 1, the remote I/O device 300 has one or more I/O units 310, and the safety controller 400 has one or more safety I/O units 410. Typical safety I/O units 410 implement the safety function.

Each I/O unit transmits and receives various types of information to and from the control target, such as the equipment or the machine. The I/O unit has, for example, one or more of the following functions: a digital input (DI) function of receiving a digital signal, a digital output (DO) function of outputting a digital signal, an analog input (AI) function of receiving an analog signal, and an analog output (AO) function of outputting an analog signal. The I/O unit may also have special functions such as proportional-integral-derivative (PID) control and motion control.

The devices connected to the network 2 shown in Fig. 1 are examples, and other devices may also be connected to the network 2. Examples of such other devices include a device with one I/O unit incorporating a communication device and a device incorporating a driver for a servomotor and a communication device.

A device connected to the network 2 may have identification information for identification on the network 2. All or some of the devices connected to the network 2 will also be collectively referred to as devices.

A programmable terminal 100 is an information processing apparatus connected to the control system 1 with the network 2. The programmable terminal 100 provides a human-machine interface (HMI) function for the control system 1. More specifically, the programmable terminal 100 is a computer that presents various screens displaying intended information managed in the control system 1 to the user in accordance with a prepared program, and also outputs a specified instruction to a specified device in response to a user operation. Although the programmable terminal 100 may be usually connected to any device included in the control system 1, the programmable terminal 100 in the configuration shown in Fig. 1 is connected to the PLC 200 via a network 3. In another implementation, the programmable terminal 100 may be directly connected to the network 2.

The programmable terminal 100 according to the present embodiment presents the current status of the control system 1 with the network 2, and information about any abnormality to the user. In particular, the programmable terminal 100 provides a user interface for easier identification of the cause of any abnormality.

### B. Hardware Configuration of Each Device

The hardware configuration of each device included in the control system 1 will now be described.

### b1: Programmable Terminal 100

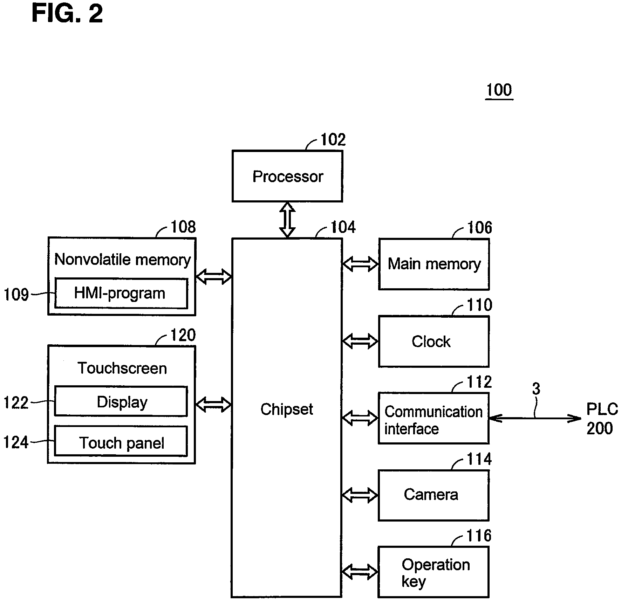

Fig. 2 is a block diagram showing the hardware configuration of the programmable terminal 100 in the control system 1 according to the present embodiment. In the programmable terminal 100, a preinstalled information processing program (or HMI-program 109) is executed to provide various user interfaces described later. More specifically, the programmable terminal 100 shown in Fig. 2 includes a processor 102, a chipset 104, a main memory 106, a nonvolatile memory 108, a clock 110, a communication interface 112, a camera 114, operation keys 116, and a touchscreen 120.

The processor 102 reads the HMI-program 109 from the nonvolatile memory 108, and expands it in the main memory 106 and executes instructions in the HMI-program 109 sequentially in accordance with clocks supplied by the clock 110. The main memory 106 is, for example, dynamic random access memory (DRAM) or static random access memory (SRAM), and is a storage for holding the HMI-program 109 and temporary data. The nonvolatile memory 108 is, for example, flash memory, and is a storage for the HMI-program 109 and various types of setting information. The chipset 104 is a circuit for supporting transmission and reception of data between the processor 102 and peripheral devices.

The communication interface 112 is a circuit that allows communication with, for example, the controller (PLC 200 in Fig. 1). The communication may be based on a network system that complies with EtherCAT (registered trademark), EtherNet/IP (registered trademark), DeviceNet (registered trademark), CompoNet (registered trademark), or another protocol, or based on a communication line system such as universal serial bus (USB) or parallel communication.

The camera 114 is installed on, for example, the surface of the programmable terminal 100, and captures an image of the user of the programmable terminal 100 or its surrounding. The image captured by the camera 114 may be used for user authentication.

The operation keys 116 are arranged on, for example, the front, side, and back surfaces of the programmable terminal 100, and receives user operations.

The touchscreen 120 functions as a display unit for presenting an image for the user, and also as an input unit for receiving a user operation. More specifically, the touchscreen 120 includes a display 122, which functions as a display unit, and a touch panel 124 on the surface of the display 122 for receiving a user operation (specifically, a touch operation on the display 122).

Some or all of the functions enabled by the processor 102 may be implemented with a hard-wired processing circuit, such as an application-specific integrated circuit (ASIC) or a field-programmable gate array (FPGA).

### b2: PLC 200

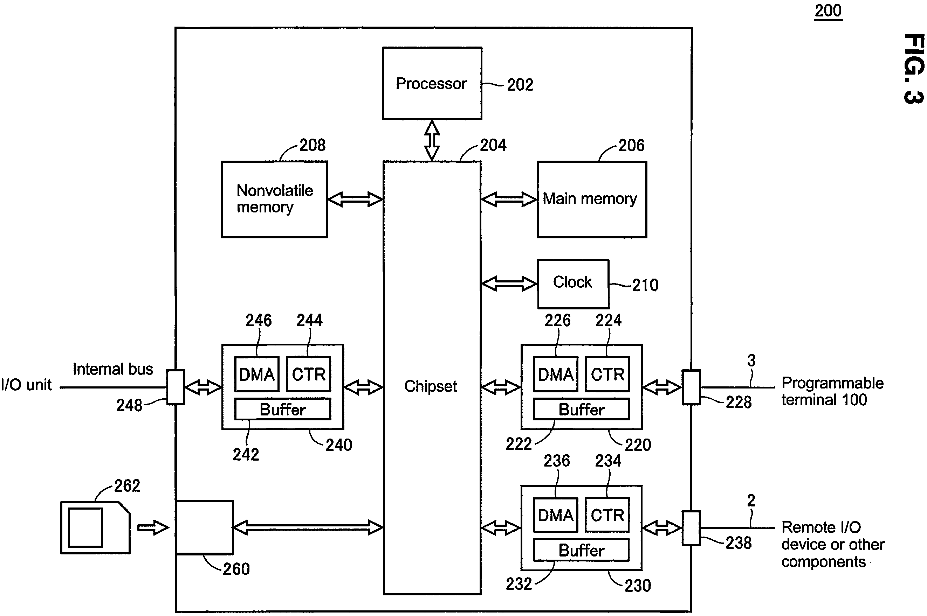

Fig. 3 is a block diagram showing the hardware configuration of the PLC 200 in the control system 1 according to the present embodiment. The PLC 200 shown in Fig. 3 controls a target by executing a preinstalled user program. More specifically, the PLC 200 shown in Fig. 3 includes a processor 202, a chipset 204, a main memory 206, a nonvolatile memory 208, a clock 210, network controllers 220 and 230, an internal bus controller 240, a communication interface 150, and a memory card interface 260.

The processor 202 reads the user program from the nonvolatile memory 208, and expands it in the main memory 206 and executes instructions in the user program sequentially in accordance with clocks supplied by the clock 210. The main memory 206 is, for example, DRAM or SRAM, and is a storage for holding the user program and temporary data. The nonvolatile memory 208 is, for example, flash memory, and is a storage for the user program and various types of setting information. The chipset 204 is a circuit for supporting transmission and reception of data between the processor 202 and peripheral devices.

The network controller 220 controls the transmission and reception of data to and from another device through the network 3. The network controller 230 controls the transmission and reception of data to and from another device through the network 2. The network controller 220 is physically connected to the network via a connector 228, and the network controller 230 is physically connected to the network via a connector 238. More specifically, the network controller 220 includes a buffer memory 222, a transfer control circuit 224, and a dynamic memory access (DMA) control circuit 226. Likewise, the network controller 230 includes a buffer memory 232, a transfer control circuit 234, and a DMA control circuit 236.

The buffer memory 222 sequentially stores packets transferred through the network 3. The transfer control circuit 224 controls the transmission and reception of packets to and from the network 3. The DMA control circuit 226 controls the access to, for example, the buffer memory.

The buffer memory 232 sequentially stores packets transferred through the network 2. The transfer control circuit 234 controls the transmission and reception of packets to and from the network 2. The DMA control circuit 236 controls the access to, for example, the buffer memory.

The internal bus controller 240 is physically connected to an internal bus via a connector 248, and relays the transmission and reception of data through the internal bus to and from the I/O unit mounted on the PLC 200. More specifically, the internal bus controller 240 includes a buffer memory 242, a transfer control circuit 244, and a DMA control circuit 246. These units function in the same manner as the corresponding units of the network controllers 220 and 230.

The memory card interface 260, onto which a memory card 262 can be mounted, reads data from and writes data to the memory card 262.

### b3: Remote I/O Device 300

The hardware configuration of the remote I/O device 300 is similar to that of the PLC 200. However, the remote I/O device 300 executes no user program, and thus the processor may be replaced with a hard-wired processing circuit, such as an ASIC or an FPGA.

### b4: Safety Controller 400

The hardware configuration of the safety controller 400 is also similar to that of the PLC 200. However, the safety controller 400 may include a dual processor and a redundant power supply to increase its fault tolerance. The I/O unit may also be dual-redundant or may have the safety function.

### C. Overview

The control system 1 according to the present embodiment uses a novel method to output information managed in the control system 1 to, for example, allow easier identification of the cause of an abnormality. The information output method (or information output function) according to the present embodiment will now be described briefly.

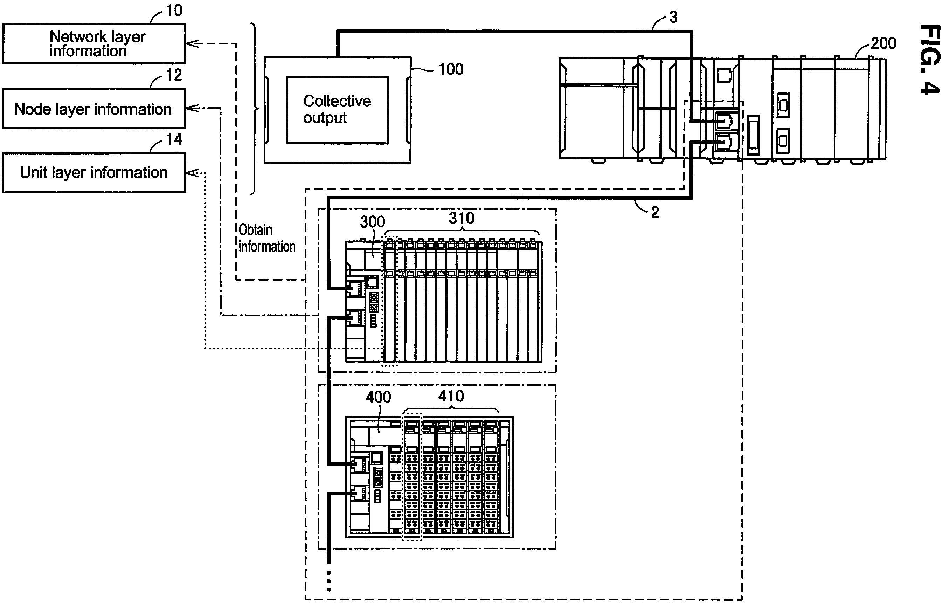

Fig. 4 is a schematic diagram describing the information output function according to the present embodiment. In the control system 1 according to the present embodiment, information sets on multiple layers (or planes) including the layer of the network 2 are output collectively. A layer herein refers to a hierarchical layer, and refers to a set of portions that are processed in parallel or that have parallel functions.

Examples of layers defined in the control system 1 shown in Fig. 4 include the layer corresponding to the overall network 2 (network layer), the layer corresponding to each node connected to the network 2 (node layer), and the layer corresponding to the controller included in each node and each I/O unit mounted on the controller (unit layer). For any of the nodes that may have another network, lower layers are defined for the second network and the nodes connected to the second network.

The information output function according to the present embodiment allows the information sets managed in these layers, namely, network layer information 10, node layer information 12, and unit layer information 14, to be collectively displayed on the programmable terminal 100.

The network layer information 10 is obtainable on the network 2, and is typically managed and held by the master node on the network 2 (PLC 200 in Fig. 4).

The node layer information 12 is obtainable from the slave nodes connected to the network 2 (e.g., the remote I/O device 300 and the safety controller 400), and typically includes information internally managed by the slave nodes.

The unit layer information 14 is obtainable from the I/O units mounted on the slave nodes (e.g., the remote I/O device 300 and the safety controller 400), and typically includes information internally managed by the I/O units.

The programmable terminal 100 or the PLC 200 connected to the programmable terminal 100 has the function of obtaining these information sets. The programmable terminal 100 collectively outputs the information obtained from each layer. The collective output of the information sets obtained from the multiple layers enables the user to readily determine the layer to be used to identify the cause of an abnormality.

Examples of output information obtained from each layer will now be described.

### D. User Interface Screen

The user interface screens provided by the control system 1 according to the present embodiment will now be described. The user interface screens illustrated below are typically displayed on the programmable terminal 100. However, the display is not limited to this example. The user interface screens may appear on a display of a support apparatus connected to the control system 1.

### d1: Display of Device List and Device Map

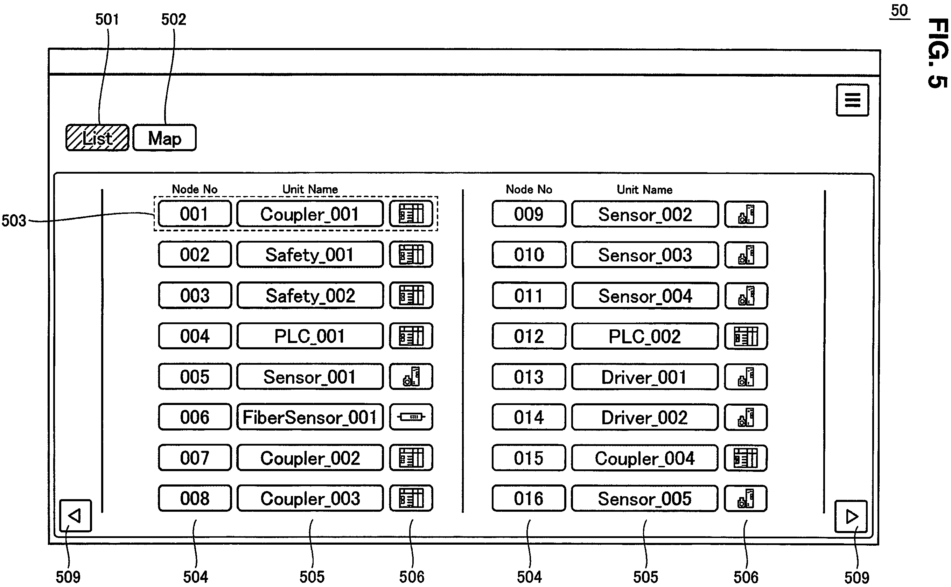

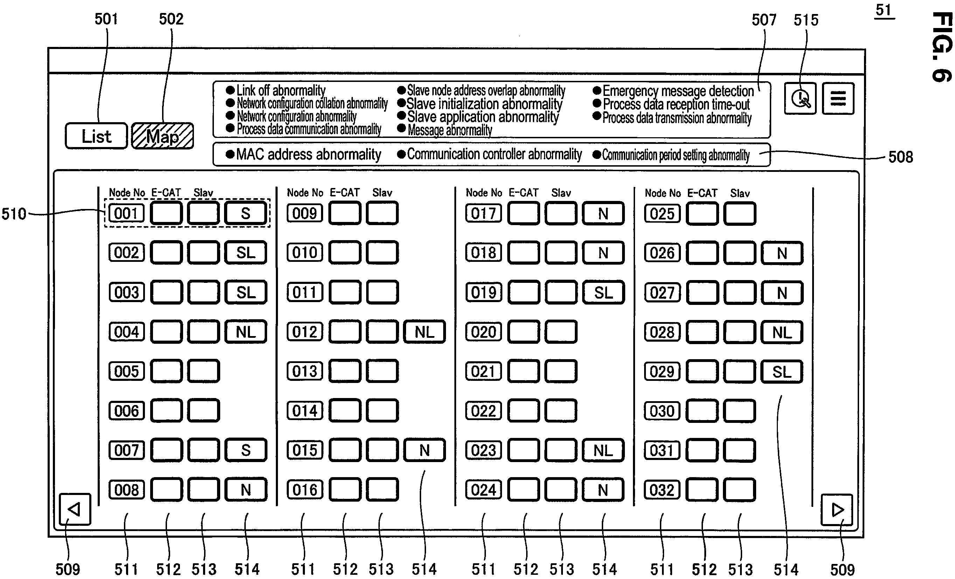

Fig. 5 shows a device list display screen provided in the control system 1 according to the present embodiment. Fig. 6 shows a device map display screen provided in the control system 1 according to the present embodiment.

The device list display screen 50 shown in Fig. 5 and the device map display screen 51 shown in Fig. 6 each include a device list button 501 and a map button 502. The user can select either of the buttons to switch between the device list display and the map display. A part of the device list that cannot fit in the single screen is displayed on a next screen. Switching to the next screen is performed by pressing one of page turning buttons 509 on each display screen.

The device list display screen 50 shows a list of slave nodes (devices) connected to the network 2. The items appearing on the device list display screen 50 are generated based on the network setting information held by the master node in the network 2 (PLC 200 in Fig. 4). The programmable terminal 100 may obtain the network setting information from the PLC 200 to dynamically generate the device list display screen 50.

More specifically, the device list display screen 50 includes a device object 503 corresponding to each slave node. Each device object 503 includes a node number 504 representing the identification information about the device on the network 2, a device name 505, and a type icon 506 indicating the type of the unit. Each node number 504 has a unique value in the same network, and this value is determined in any manner or based on a predetermined rule. Each device name 505 may be determined by the user in any manner or may be a value preset in the device.

Each type icon 506 may have a design that readily shows the type of the device. The type icons 506 may represent various sensors such as a PLC, a safety controller, a remote I/O device, and a fiber sensor, as well as servo drivers, inverters, and visual sensors. A user selecting some or all of the type icons 506 may cause the display to transition to the screen specific to the selected device. The device specific screens will be described later.

The device map display screen 51 shows the status information (status information) about the multiple layers associated with one or more devices connected to the network 2.

The device map display screen 51 includes communication abnormality indication areas 507 and 508. The communication abnormality indication area 507 mainly indicates an abnormality that may occur dynamically during the operation of the network 2. The communication abnormality indication area 508 mainly indicates an abnormality that may occur when the network 2 is configured. The abnormality is detected based on the transfer status in a communication frame managed by the master node in the network 2 (PLC 200 in Fig. 4) or a message sent from each slave. The abnormalities appearing in the communication abnormality indication area 507 are often detected in the network layer and the transport layer. The abnormalities appearing in the communication abnormality indication area 508 are often detected in the physical layer and the data link layer.

The device map display screen 51 also includes a device object 510 for each slave node connected to the network. Each device object 510 includes a node number 511 representing the identification information about the corresponding device on the network 2, a network status object 512 representing the communicating status in the network 2, a node status object 513, and a unit status object 514.

Each node number 511 has a unique value in the same network, and this number is determined in any manner or based on a predetermined rule, like the node number 504 in the device map display screen 51.

The network status object 512 is visualized status information indicating the communicating status of each slave node in the network 2 (corresponding to the network layer information 10), and its display mode changes depending on the status of the slave node (e.g., normal or abnormal). In one example, when the communicating status of a slave node in the network 2 is normal, the light on the entire or edge of the network status object 512 is green, whereas when the communicating status in the network 2 is abnormal, the light on the entire or edge of the network status object 512 may be red or may blink in red.

Additionally, the communicating status in the network 2 may appear to be subdivided. For example, the communicating statuses of each slave node in the network 2, as described below, may be determined based on the information managed by the master node in the network 2, and the determined communicating status may be represented visually.
Status 1 (gray): node unrelated to communication or unused
Status 2 (blinking in red): an abnormality occurring in the network communication system
Status 3 (green): communicating process data
Status 4 (blinking in green): ready to communicate a message
Status 5 (yellow): leaving
Status 6 (blinking in yellow): waiting for reentry (after left)
Status 7 (grayed out): node disabled

The node status object 513 is visualized status information indicating the operating status of each slave node connected to the network 2 (corresponding to the node layer information 12), and its display mode changes depending on the operating status of the slave node (e.g., normal or abnormal). In one example, when the operating status of a slave node is normal, the light on the entire or edge of the node status object 513 is green, whereas when the operating status of the slave node is abnormal, the light on the entire or edge of the node status object 513 may be red or may blink in red.

Additionally, the operating status of a slave node may appear to be subdivided. For example, the communicating status of each slave node, as described below, may be determined based on the slave node internal information, and the determined communicating status may be represented visually.
Status 1 (green): normal
Status 2 (blinking red): under abnormal slave node condition
Status 3 (grayed out): unused node

The status information indicated by the node status object 513 (corresponding to the node layer information 12) may vary in accordance with the type of the slave node. For example, for a slave node on which one or more I/O units such as a PLC, a remote I/O device, and a safety controller can be additionally mounted, the node layer information 12 may include the information about the mounted I/O units managed by the slave node. However, detailed information managed by each I/O unit is included in the unit layer information 14.

For a slave node that is a fiber sensor or another sensor, a servo driver, an inverter, or a visual sensor, the node layer information 12 may include detailed information managed by the slave node.

The unit status object 514 is visualized status information indicating the operating statuses of slave nodes of predetermined types (typically including a PLC, a remote I/O device, and a safety controller) (corresponding to the unit layer information 14), and its display mode changes depending on the operating status of each device (e.g., whether the device and its I/O units are both operating normally). In one example, when the operating status of such a slave node is normal, the light on the entire or edge of the unit status object 514 is green, whereas when the operating status is not normal, the light on the entire or edge of the unit status object 514 may be red or may blink in red.

For each device other than the slave nodes of predetermined types, the unit status object 514 does not appear (or remains hidden). In other words, the unit status objects 514 are enabled for the slave nodes of predetermined types in the slave node list.

Each unit status object 514 may be an icon indicating the type of the device connected to the node. In the example shown in Fig. 6, a unit status object 514 is one of the four icons, SL, S, NL, and N. More specifically, the unit layer information 14 may be output together with the type of the device having the operating status indicated by the unit status object 514.

The icon SL indicates the status in which a safety controller is connected as a slave node. The icon S indicates the status in which a remote I/O device including a safety I/O unit is connected as a slave node. The icon NL indicates the status in which a PLC (other than a safety controller) is connected as a slave node. The icon N indicates the status in which a remote I/O device including an I/O unit (other than a safety I/O unit) is connected as a slave node.

As described, the device map display screen 51 shown in Fig. 6 displays, for each slave node, the network status object 512 (network layer information 10), the corresponding node status object 513 (node layer information 12), and the corresponding unit status object 514 (unit layer information 14) in a manner arranged in line. More specifically, the device map display screen 51 shown in Fig. 6 represents the output of the communicating status and the operating status of each slave node in the network 2 associated with the slave node.

The in-line arrangement of the information items in different layers for each single slave node allows easier identification of the cause of an abnormality.

All or some of the network status object 512 (network layer information 10), the node status object 513 (node layer information 12), and the unit status object 514 (unit layer information 14) appearing on the device map display screen 51 may each have different display modes that depend on their statuses. The display mode that changes depending on the status allows the user to readily determine the status of each layer of each slave node.

### d2: Display of Safety Controller Status

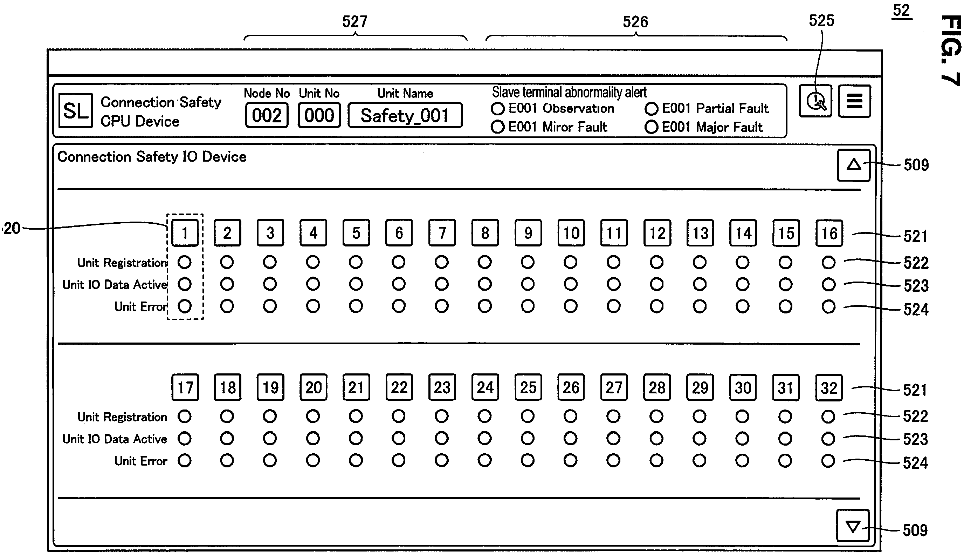

Fig. 7 shows a safety controller status display screen provided in the control system 1 according to the present embodiment. When a unit status object 514 with the icon SL indicating a safety controller is selected on the device map display screen 51 shown in Fig. 6, the safety controller status display screen 52 shown in Fig. 7 appears. The safety controller status display screen 52 includes more detailed information about the selected safety controller than the information appearing on the device map display screen 51 shown in Fig. 6. More specifically, selecting the unit status object 514 (unit layer information 14) causes more detailed information to be output than the previously output unit layer information 14 about the corresponding device.

The safety controller status display screen 52 includes slave identification information 527 and a slave abnormality indication area 526. The slave identification information 527 includes the node number of the corresponding safety controller in the network 2, the unit number of the safety controller in the node, and the name of the safety controller. The slave abnormality indication area 526 indicates an abnormality in the corresponding safety controller. Such abnormalities are monitored and managed by the safety controller.

The safety controller status display screen 52 includes a status indication object 520 for each safety I/O unit mounted on the safety controller. Each status indication object 520 includes the unit number 521 assigned to its unit, a registration indicator 522 indicating whether the unit has been registered on the setting information, a refresh indicator 523 indicating the status of input-output refresh in the unit, and an error indicator 524 indicating the presence of an error in the unit.

When a device including one or more safety I/O units (or ordinary I/O units) and an arithmetic unit (specifically, a safety controller or a PLC) for transmitting and receiving intended data between them is selected on the device map display screen 51 shown in Fig. 6, a list of statuses of the one or more safety I/O units (or ordinary I/O units) managed by the arithmetic unit is output as the detailed information as shown in Fig. 7.

### d3: Display of Safety I/O Unit Status

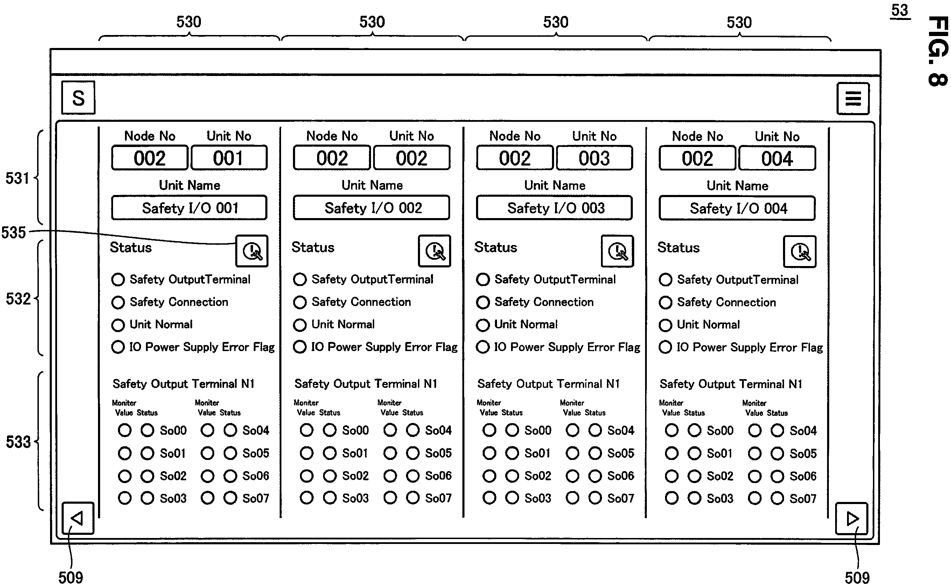

Fig. 8 shows a safety I/O unit status display screen 53 provided in the control system 1 according to the present embodiment. When an icon indicating a unit number 521 is selected on the safety controller status display screen 52 shown in Fig. 7, the safety I/O unit status display screen 53 appears. The safety I/O unit status display screen 53 includes information about the unit having the selected unit number.

The safety I/O unit status display screen 53 includes unit identification information 531, a unit status indicator 532, and a terminal status indicator 533. The unit identification information 531 is information for identifying each safety I/O unit mounted on the safety controller, and includes the node number of the corresponding safety controller in the network 2, the unit number assigned to each safety I/O unit, and the name of each safety I/O unit. The unit status indicator 532 indicates the status of each safety I/O unit (e.g., whether the safety I/O unit is operating normally or whether the external power supply is working properly). The terminal status indicator 533 indicates the status of a signal input to an input terminal of each safety I/O unit or a signal output from an output terminal.

Each of the safety I/O units may hold more detailed information. In that case, the more detailed information may be presented in addition to the information displayed on the safety I/O unit status display screen 53 shown in Fig. 8. Examples of such detailed information include the operating time, the remaining life, the history of failures, and the installation site (latitude-longitude information).

Selecting any of the safety I/O units (or ordinary I/O units) listed on the safety controller status display screen 52 shown in Fig. 7 causes output of information about the input or output statuses of the corresponding safety I/O units (or ordinary I/O units).

When a device including one or more safety I/O units (or ordinary I/O units) for collecting and outputting the data to be used in another arithmetic unit (specifically, a safety controller or a PLC) through the network 2 is selected on the device map display screen 51 shown in Fig. 6, the input or output statuses of the individual safety I/O units (or ordinary I/O units) are output as the detailed information as shown in Fig. 7.

### d4: Display of Controller Status

When a unit status object 514 with the icon NL, which indicates a PLC (other than a safety controller), is selected on the device map display screen 51 shown in Fig. 6, a screen similar to the safety controller status display screen 52 shown in Fig. 7 may appear. d5: Display of I/O Unit Status

When a unit status object 514 with the icon N, which indicates a remote I/O device including an I/O unit (other than a safety I/O unit), is selected on the device map display screen 51 shown in Fig. 6, a screen similar to the safety I/O unit status display screen 53 shown in Fig. 8 may appear. In some embodiments, when an icon indicating a unit number 521 is selected on the safety controller status display screen 52 shown in Fig. 7, the current screen may transition to a screen similar to the safety I/O unit status display screen 53 shown in Fig. 8.

### d6: Display of Remote I/O Device Status

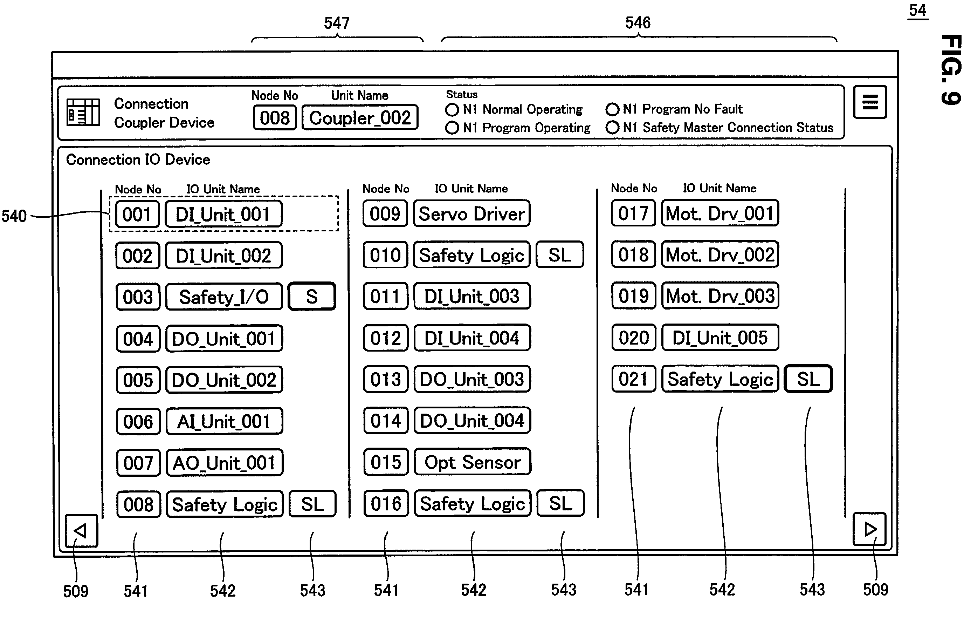

Fig. 9 shows a remote I/O device status display screen provided in the control system 1 according to the present embodiment. When a type icon 506 indicating a remote I/O device is selected on the device list display screen 50 shown in Fig. 5, the remote I/O device status display screen 54 shown in Fig. 9 appears.

The remote I/O device status display screen 54 includes slave identification information 547 and a status indication area 546. The slave identification information 547 includes the node number and the name of the corresponding remote I/O device in the network 2. The status indication area 546 indicates the operating status of the corresponding remote I/O device.

The remote I/O device status display screen 54 further includes device objects 540 for each device mounted on the corresponding remote I/O device. Each device object 540 includes a node number 541 representing the identification information about the mounted device on the internal bus of the corresponding remote I/O device, a mounted-device name 542, and a detailed information button 543. Each node number 541 has a unique value on the same internal bus, and this value is determined in any manner or based on a predetermined rule. Each mounted-device name 542 may be determined by the user in any manner or may be a value preset in the device.

The detailed information button 543 is displayed in a manner similar to the display mode of the unit status objects 514 on the device map display screen 51 shown in Fig. 6. When a detailed information button 543 is selected, the safety controller status display screen 52 shown in Fig. 7 or the safety I/O unit status display screen 53 shown in Fig. 8 appears.

### d7: Abnormality Message Filtering

The control system 1 according to the present embodiment allows the programmable terminal 100 to collect abnormality information (or abnormality messages) indicating abnormalities that have occurred in each layer. However, such abnormalities in different layers displayed in a manner arranged in line cannot allow easy identification of the cause of each abnormality. To allow easier identification of the cause of an abnormality, the control system 1 according to the present embodiment extracts abnormality messages associated with a target layer through filtering, and presents the extracted abnormality messages to the user in a manner associated with a user interface screen described above.

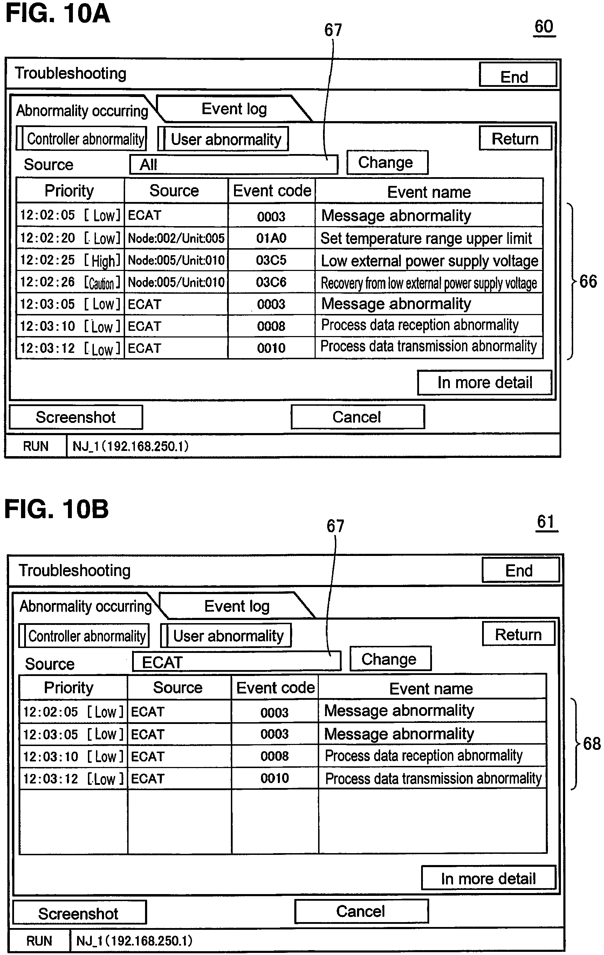

Figs. 10A and 10B show abnormality message display screens provided in the control system 1 according to the present embodiment. In the control system 1 according to the present embodiment, an abnormality message includes fields storing a priority, a source, an event code, and an event name. The source field corresponds to information indicating a source of each abnormality message. The source field is used to filter abnormality messages on a layer basis.

In the control system 1 according to the present embodiment, abnormality messages may also include layer information described above. Typical examples of such abnormality messages include an abnormality message indicating an abnormality in the network 2 (typically obtained from the master node) and an abnormality message indicating an abnormality in any slave node (typically obtained from each slave node).

Fig. 10A shows a message display screen 60 listing all generated abnormality messages. On a list 66 of abnormality messages displayed on the message display screen 60, a predetermined condition is set in a filtering box 67 to selectively extract an abnormality message that meets the set condition.

Fig. 10B shows a message display screen 61 on which the abnormality messages associated with the network 2 (specifically, abnormality messages associated with the network layer information 10) are selectively displayed through filtering. The message display screen 61 shows a list 68 of abnormality messages associated with the network 2 extracted from the list 66 displayed on the message display screen 60.

The user can refer to the list 68 to readily identify the cause of an abnormality in the network 2.

### d8: Screen Transition

In the control system 1 according to the present embodiment, an extraction condition may be directly set in the display screen shown in Fig. 10. In some embodiments, selecting a target layer on a user interface screen described above may automatically cause message filtering based on the selected layer. Transitions between user interface screens will now be described in a manner associated with the abnormality message displaying function.

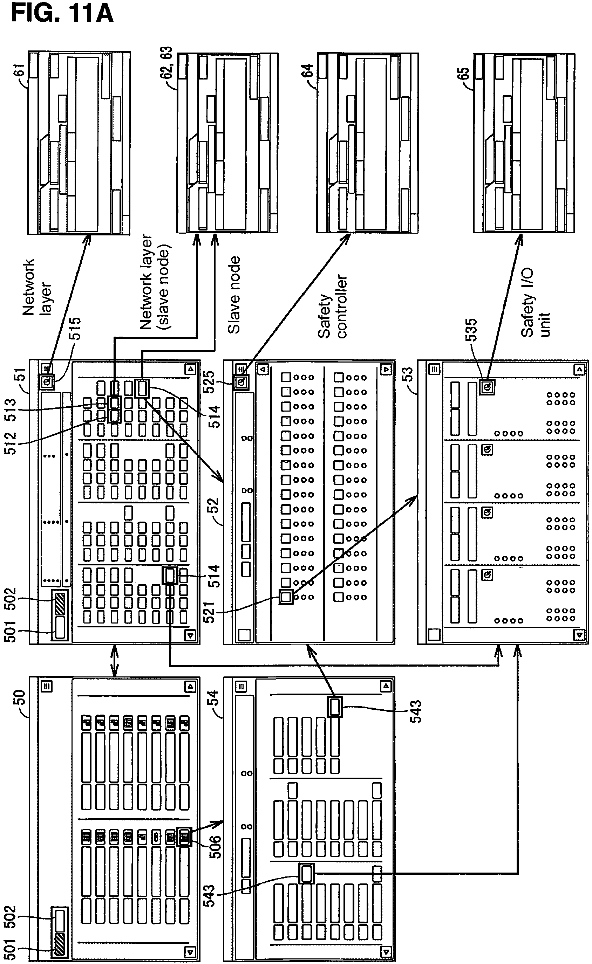

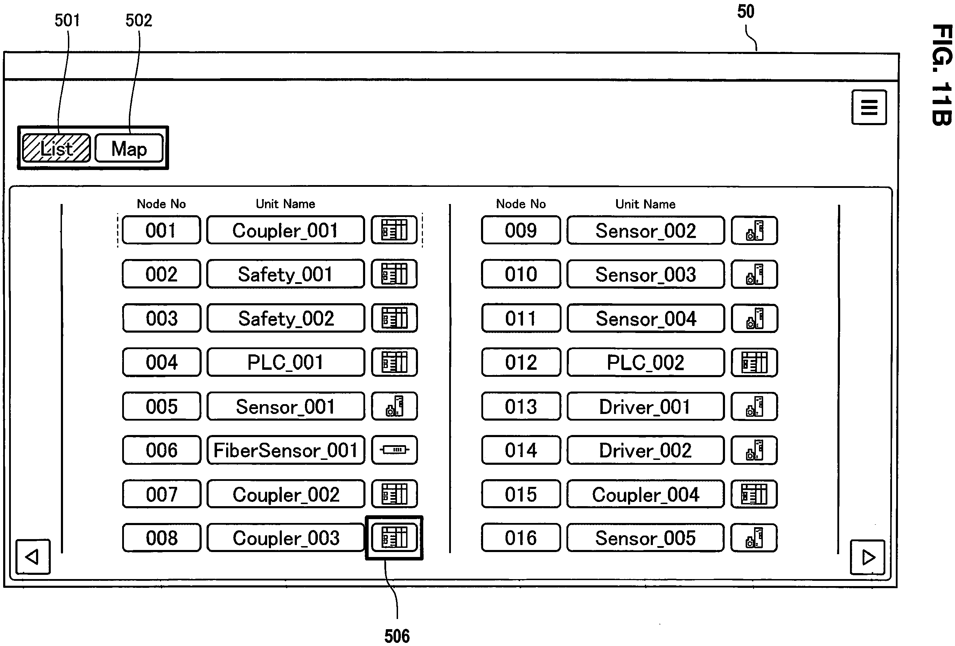

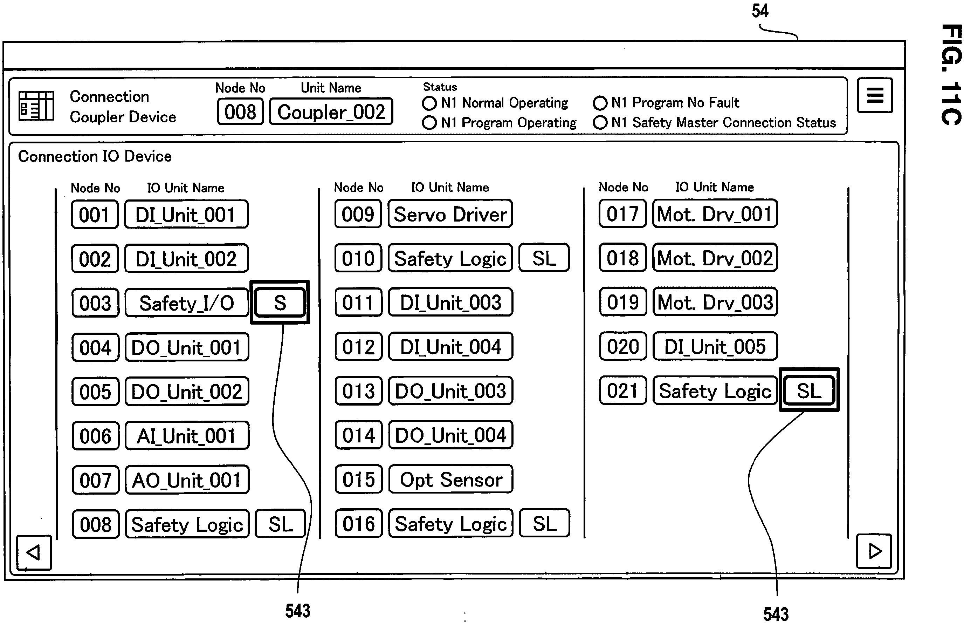

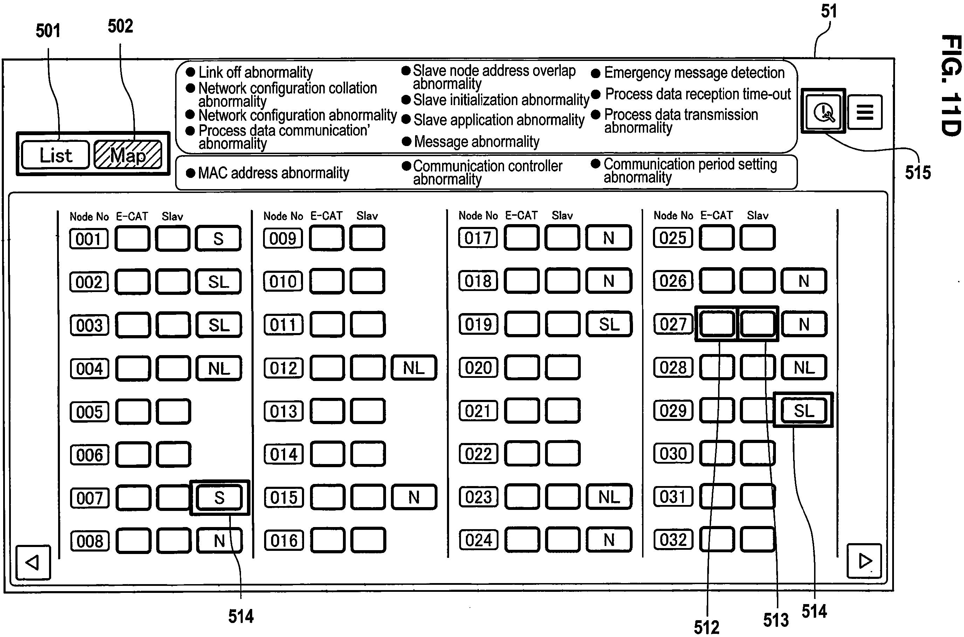

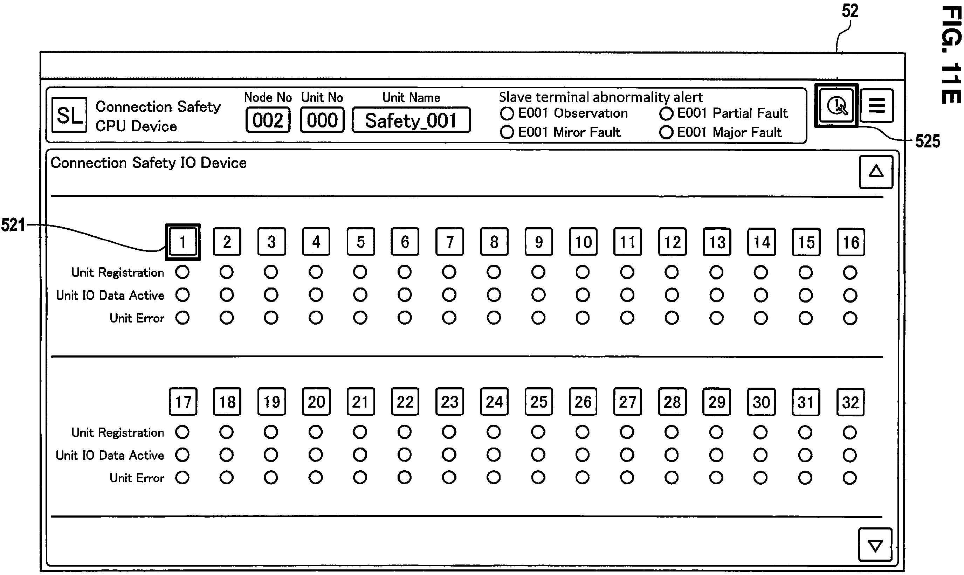

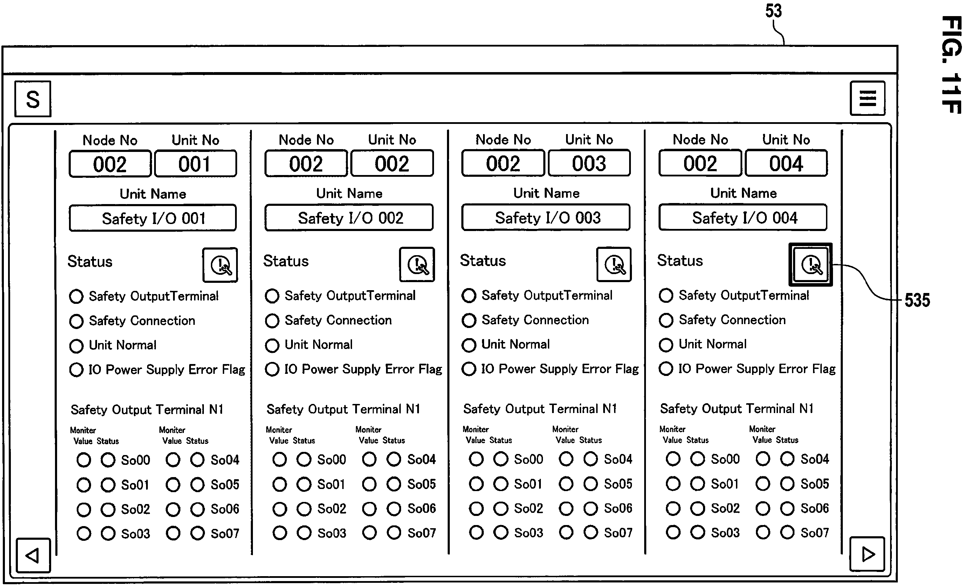

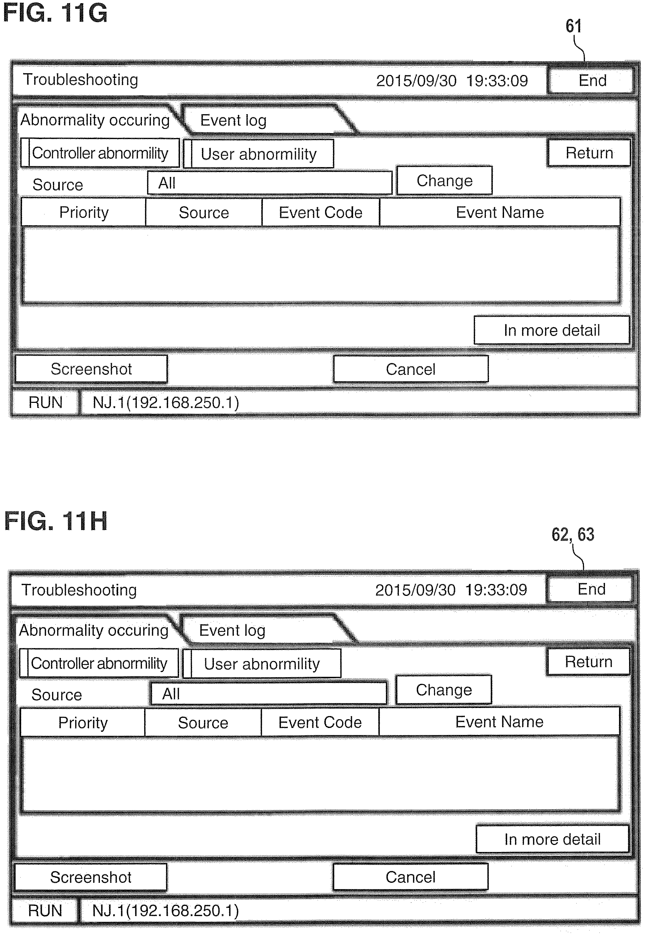

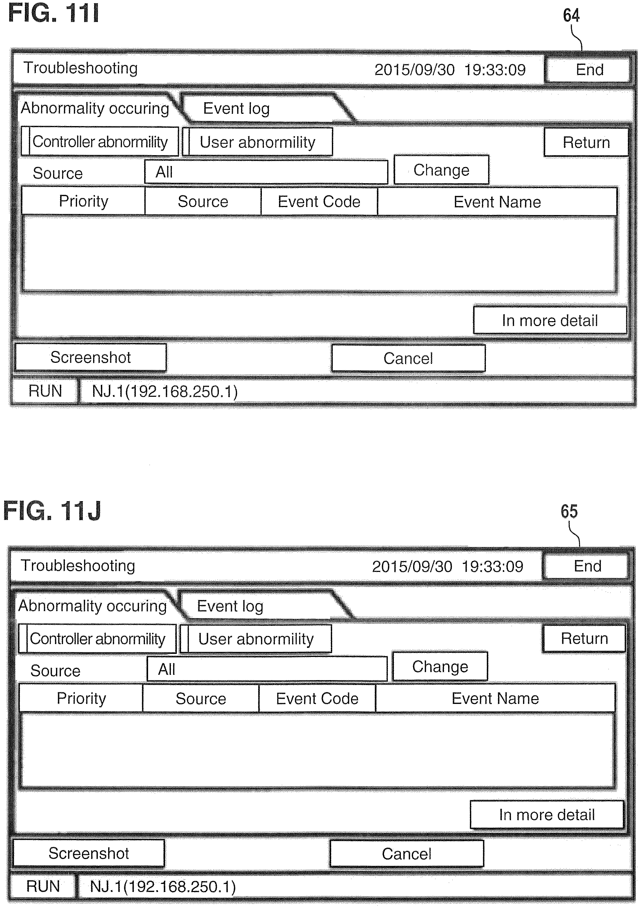

Fig. 11 shows the transitions of user interface screens provided in the control system 1 according to the present embodiment. With reference to Fig. 11, the device list display screen 50 (refer to Fig. 5) or the device map display screen 51 (refer to Fig. 6) is displayed as the initial status. The user selects the device list button 501 or the map button 502 to switch between the display screens.

The device map display screen 51 includes an abnormality message button 515. Selecting the abnormality message button 515 displays the message display screen 61 prepared through message filtering based on the network layer. The message display screen 61 prepared through the message filtering selectively shows abnormality messages associated with the network 2. More specifically, selectively presenting abnormality messages associated with the network layer information 10 allows the user to easily identify the cause of each abnormality in the network layer.

Selecting the network status object 512 associated with any slave node on the device map display screen 51 displays a message display screen 62 prepared through message filtering based on the corresponding slave node in the network layer. The message display screen 62 prepared through the message filtering selectively shows abnormality messages generated in the selected slave node from the abnormality messages associated with the network 2. More specifically, selectively presenting abnormality messages associated with the target slave node in the network layer information 10 allows the user to easily identify the cause of each abnormality in the target slave node.

Similarly, selecting the node status object 513 associated with any slave node on the device map display screen 51 displays a message display screen 63 prepared through message filtering based on the node layer for the corresponding slave node. The message display screen 63 prepared through the message filtering selectively shows abnormality messages associated with the communicating status of the corresponding slave node. More specifically, selectively presenting the node layer information 12 on the target slave node allows the user to easily identify the cause of each abnormality in the slave node.

Selecting the unit status object 514 associated with any slave node on the device map display screen 51 displays the safety controller status display screen 52 (refer to Fig. 7) or the safety I/O unit status display screen 53 (refer to Fig. 8) in accordance with the type of the selected slave node (unit). More specifically, when a slave node that is a safety controller (or a PLC) is selected, the current screen transitions to the safety controller status display screen 52, whereas when a slave node that is a safety I/O unit (or an ordinary I/O unit) is selected, the current screen transitions to the safety I/O unit status display screen 53.

In this manner, when the network status object 512 indicating the communicating status of any slave node in the network 2 is selected on the device map display screen 51, abnormality messages generated by the selected slave node are extracted from the abnormality messages associated with the network 2 (specifically, abnormality messages associated with the network layer information 10), and are output onto the message display screen 62. In some embodiments, when the node status object 513 indicating the operating status of any slave node is selected, abnormality messages for the selected slave node are extracted and are output onto the message display screen 63.

When the unit number 521 associated with any unit is selected on the safety controller status display screen 52, the safety I/O unit status display screen 53 (refer to Fig. 8) corresponding to the selected unit appears. In this manner, a slave node is selected on the device map display screen 51, and then a unit is selected on the safety controller status display screen 52. This procedure allows the operation and the status of the control system 1 to be checked from upper layers to lower layers through a series of operations.

The safety controller status display screen 52 includes an abnormality message button 525. Selecting the abnormality message button 525 displays a message display screen 64 prepared through message filtering based on the unit layer corresponding to the displayed safety controller (or PLC). The message display screen 64 prepared through the message filtering selectively shows abnormality messages generated in the displayed safety controller (or PLC) and the safety I/O units (or ordinary I/O units) mounted on this controller. More specifically, when the operating statuses of slave nodes of predetermined types (typically including a PLC, a remote I/O device, and a safety controller) are indicated, the user selects the abnormality message button 525 on the safety controller status display screen 52. In response to the user operation, the abnormality messages generated by the devices having the indicated operating statuses and other devices connected to these devices are extracted from the abnormality messages generated by the slave nodes, and are output onto the message display screen 64.

In this manner, selectively presenting the abnormality messages associated with the selected safety controller (or PLC) allows the user to easily identify the cause of abnormalities in each slave node or lower layers.

The safety I/O unit status display screen 53 includes abnormality message buttons 535. Selecting one of the abnormality message buttons 535 displays a message display screen 65 prepared through message filtering based on the unit layer corresponding to the selected unit. The message display screen 65 prepared through the message filtering selectively shows the abnormality messages generated in the selected safety I/O unit (or ordinary I/O unit). More specifically, when the input or output status of a safety I/O unit (or ordinary I/O unit) mounted on the arithmetic unit (specifically, the safety controller or the PLC) is indicated, the user selects one of the abnormality message button 535 on the safety I/O unit status display screen 53. In response to the user operation, the abnormality messages generated by the safety I/O unit (or ordinary I/O unit) having the indicated the status are extracted from the abnormality messages generated by the slave node, and are output onto the message display screen 65.

In this manner, selectively presenting the abnormality messages associated with the selected safety I/O unit (or ordinary I/O unit) to the user allows the user to easily identify the cause of an abnormality in each node or lower layers.

When the type icon 506 associated with any slave node, which is a remote I/O device, is selected on the device list display screen 50, the remote I/O device status display screen 54 (refer to Fig. 9) corresponding to the selected slave node appears. Additionally, when a detailed information button 543 is selected on the remote I/O device status display screen 54, the safety controller status display screen 52 (refer to Fig. 7) or the safety I/O unit status display screen 53 (refer to Fig. 8) appears in accordance with the type of the selected device (unit). In this manner, the screen can switch sequentially even for a controller and an I/O unit connected at different stages, and thus the operation and the status of the control system 1 can be checked from upper layers to lower layers through a series of operations.

### d9: Use Cases

Troubleshooting (including determining the cause of an abnormality, detecting the cause, recovery, and clearing the abnormality) through a user interface screen described above can have use cases listed below.

### Case (1) A shutdown due to an abnormality in a network or any device during operation of an apparatus

The user refers to the device map display screen 51 (Fig. 6) and the message display screen 61 (Fig. 11) to determine whether the abnormality has occurred in the network or in the controller and I/O units. Based on the result of the determination about the abnormality, the user checks relevant information among the network layer information 10, the node layer information 12, and the unit layer information 14 to identify the site at which the abnormality has occurred.

### Case (2) A device shutdown in accordance with a safety logic during operation of an apparatus

The user refers to the safety controller status display screen 52 (refer to Fig. 7) or the safety I/O unit status display screen 53 (refer to Fig. 8) corresponding to the safety controller in which the safety logic has been implemented, to identify the input signal that has caused the shutdown.

### Case (3) A device failing to work at the system startup due to, for example, miswiring

The user refers to the safety I/O unit status display screen 53 (refer to Fig. 8) about the target safety I/O unit to determine whether an input signal and an output signal are properly input and output.

### E. Modifications

The user interface screens described above may also have additional functions described below.

### e1: Location Display

When a safety controller, a PLC, and a remote I/O device are installed at different sites as in the control system 1 shown in Fig. 1, the installation location of a device with an abnormality may not be readily determined. In that case, a user interface screen may visually represent the installation location of each device.

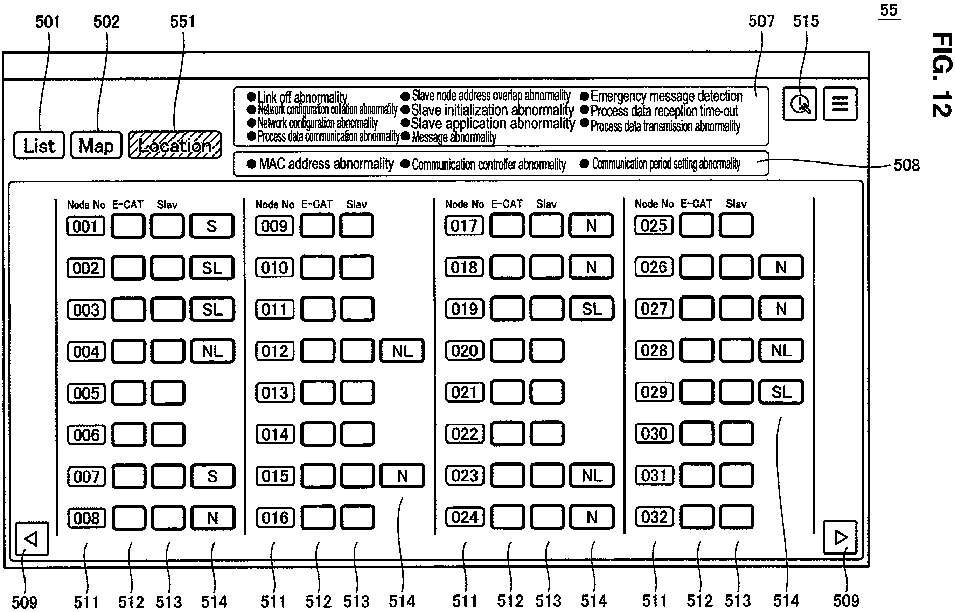

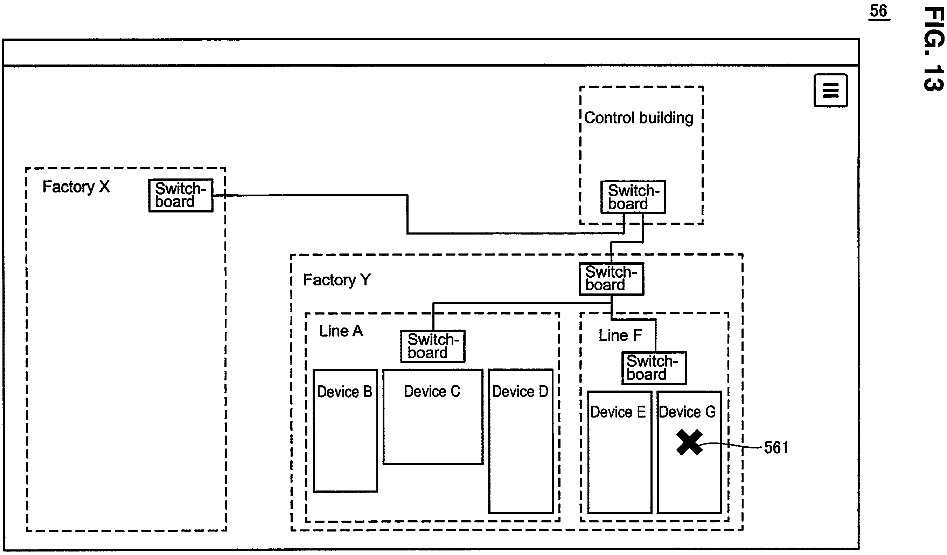

Fig. 12 shows another device map display screen provided in the control system 1 according to the present embodiment. Fig. 13 shows a location display screen provided in the control system 1 according to the present embodiment.

The device map display screen 55 shown in Fig. 12 includes a location button 551, in addition to the device list button 501 and the map button 502. Selecting the location button 551 displays the location display screen 56 shown in Fig. 13.

The location display screen 56 shows a top view of equipment incorporating the control system 1, and a location indication object 561 indicating the location of a target device (e.g., a device with an abnormality or a device preselected by the user), which is superimposed on the top view.

The user can see the location indication object 561 on the top view to readily determine the location of an intended device.

### e2: Multilayer Display

Although Fig. 6 shows the device map display screen 51 listing sets of information about the three layers, namely, the network layer, the node layer, and the unit layer, sets of information about more layers may be displayed as a list.

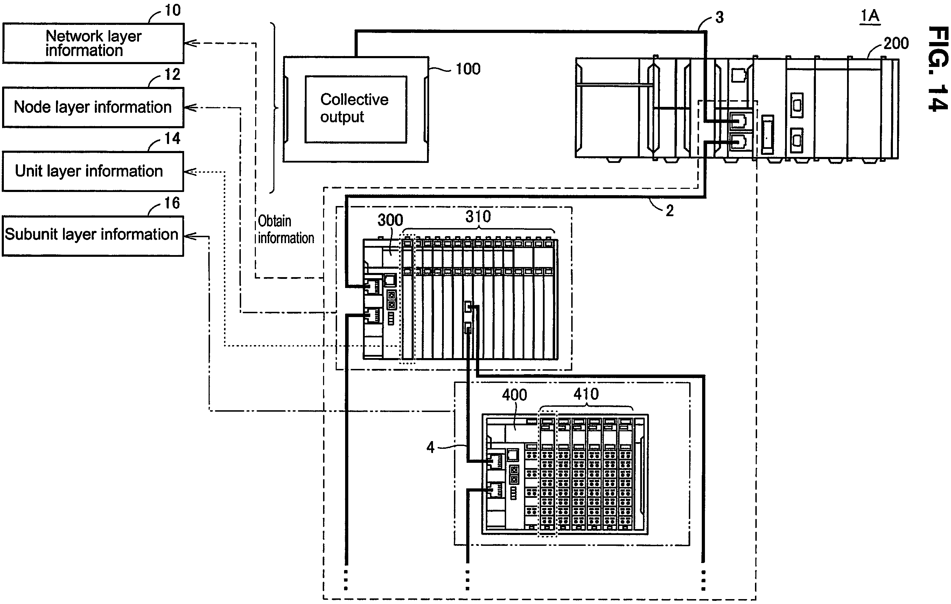

Fig. 14 is a schematic diagram showing another configuration of the control system according to the present embodiment. In the control system 1A shown in Fig. 14, a PLC 200 is connected to a remote I/O device 300 through a network 2. Any unit mounted on the remote I/O device 300 is connected to a safety controller 400 through another network 4. In this system configuration, a layer lower than the layers corresponding to the safety controller 400 and each safety I/O unit mounted on the safety controller 400 may be defined, and will also be referred to as a subunit layer. In this case, subunit layer information 16 managed in the subunit layer, as well as the network layer information 10, the node layer information 12, and the unit layer information 14, may be collectively displayed on the programmable terminal 100.

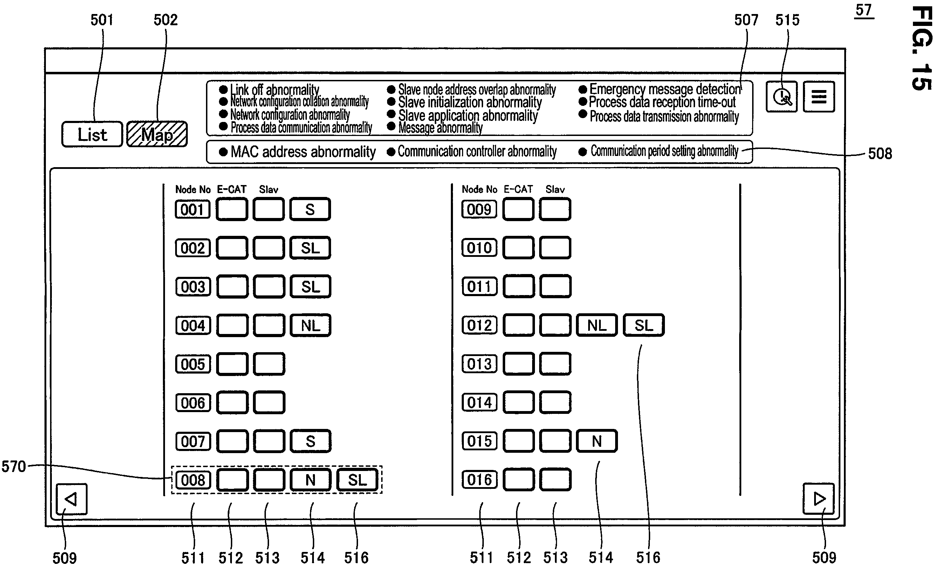

Fig. 15 shows another device map display screen provided in the control system 1 according to the present embodiment. The device map display screen 57 shown in Fig. 15 includes device objects 570 for each slave node connected to the network. Each device object 570 includes a node number 511 representing the identification information about the corresponding device on the network 2, a network status object 512 representing the communicating status in the network 2, a node status object 513, a unit status object 514, and a subunit status object 516.

The subunit status object 516 is visualized information corresponding to the subunit layer (subunit layer information 16), and its display mode changes depending on the operating status of each device (e.g., the status of a safety controller or a safety I/O unit connected under a unit). In the same manner as the unit status object 514, the subunit status object 516 may be an icon indicating the type of the connected device.

The basic display and the operation of the subunit status object 516 are the same as those of the unit status object 514 described above, and will not be described in detail.

As described above, any of the slave nodes connected to the network 2 may include a safety I/O unit (or an ordinary I/O unit) connected to the network 4 other than the network 2. In this case as well, the status information (subunit layer information 16) indicating the status of the safety I/O unit (or the ordinary I/O unit) connected to the network 4 is obtained. The device map display screen 57 shown in Fig. 15 displays, for each slave node, the network status object 512 (network layer information 10), the corresponding node status object 513 (node layer information 12), the corresponding unit status object 514 (unit layer information 14), and the corresponding subunit status object 516 (subunit layer information 16) in a manner arranged in line. The in-line arrangement of the information items in many different layers for each single slave node allows easier identification of the cause of an abnormality.

The display is not limited to the device map display screen 57 shown in Fig. 15, and information items associated with more layers may be collectively displayed. The list of information items associated with multiple layers allows the user to easily identify the cause of an abnormality by focusing on the relevant layer.

### F. Procedure

A procedure used in the control system 1 according to the present embodiment for providing a user interface screen will now be described.

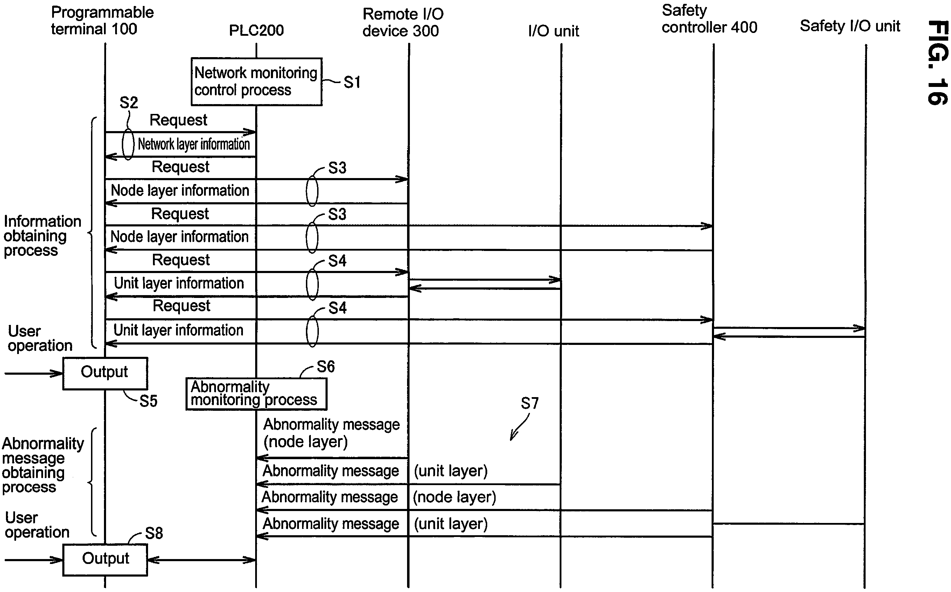

Fig. 16 is a sequence diagram showing the procedure for providing a user interface screen in the control system 1 according to the present embodiment. With reference to Fig. 16, the PLC 200 periodically performs network monitoring control including checking for an abnormality and determining the operating status in the network 2 (step S1). The network monitoring control enables the PLC 200 to obtain network layer information 10.

The programmable terminal 100 performs the information obtaining process defined in steps S2 to S4.

More specifically, the programmable terminal 100 transmits a request for the network layer information 10 to the PLC 200, and the PLC 200 responds to the request to return the network layer information 10 (step S2).

The programmable terminal 100 transmits a request for node layer information 12 to the remote I/O device 300 via the PLC 200, and the remote I/O device 300 responds to the request to return the node layer information 12 (step S3). Similarly, the programmable terminal 100 transmits a request for node layer information 12 to the safety controller 400 via the PLC 200, and the safety controller 400 responds to the request to return the node layer information 12 (step S3). The processing in step S3 is repeated the number of times equal to the number of slave nodes connected to the network 2.

The programmable terminal 100 transmits a request for unit layer information 14 to each I/O unit via the PLC 200 and the remote I/O device 300, and the I/O unit responds to the request to return the unit layer information 14 (step S4). Similarly, the programmable terminal 100 transmits a request for unit layer information 14 to each safety I/O unit via the PLC 200 and the safety controller 400, and the safety I/O unit responds to the request to return the unit layer information 14 (step S4). The processing in step S4 is usually repeated the number of times equal to the number of units (or devices) mounted on the safety controller, the PLC, and the remote I/O device. However, the processing may not be performed in every period but may be performed on demand from a user operation.

In response to a user operation, the programmable terminal 100 outputs a user interface screen based on the information obtained in the processing in steps S2 to S4 (step S5). One of the user interface screens shown in Figs. 5 to 13 is displayed through the processing in step S5.

The PLC 200 also monitors for an abnormality that may occur in the network 2 of the control system 1 (abnormality monitoring in step S6). The devices at lower layers transfer abnormality messages to the PLC 200 (step S7).

In step S7, when an abnormality is detected in the remote I/O device 300, the abnormality message (node layer) is transferred to the PLC 200. Similarly, when an abnormality is detected in the safety controller 400, the abnormality message (node layer) is transferred to the PLC 200. When an abnormality is detected in an I/O unit mounted on the remote I/O device 300, the abnormality message (unit layer) is transferred to the PLC 200 via the remote I/O device 300. Similarly, when an abnormality is detected in a safety I/O unit mounted on the safety controller 400, the abnormality message (unit layer) is transferred to the PLC 200 via the safety controller 400.

In response to a user operation, the programmable terminal 100 provides the message display screens 60 to 64 (outputting in step S8) based on the group of abnormality messages obtained in the processing in step S7 described above.

The processing steps described above are implemented sequentially or as appropriate based on a user operation.

The implementation of the method for obtaining information and abnormality messages from layers shown in Fig. 16 are illustrative and are not limited to the implementation. For example, abnormality messages may not be collected on the PLC 200 but may be held in each slave node, and the programmable terminal 100 may obtain abnormality messages from each slave node in response to a request. In some embodiments, each slave node may transfer its layer information and abnormality messages to the programmable terminal 100.

The method for obtaining the layer information and the abnormality messages may be determined as appropriate depending on the system configuration and the processing capability of each device.

### G. Advantages

The present embodiment allows a control system with multiple networked devices to check the communicating status and/or the operating status for each layer, and thus allows efficient troubleshooting for identifying the cause of an abnormality. This shortens the recovery time taken to clear the abnormality.

The present embodiment allows abnormality messages generated at any locations in the networked control system to be checked for each layer. The abnormality messages are thus efficiently examined as information for identifying the cause of the abnormality, and the cause is determined efficiently.

The embodiments disclosed herein are only illustrative in all respects and should not be construed to be restrictive. The scope of the present invention is designated by the appended claims, and it is intended that all changes are contained in the claims and equivalent meanings and ranges.

### REFERENCE SIGNS LIST

- 1, 1A: control system
- 2, 3, 4: network
- 10: network layer information
- 12: node layer information
- 14: unit layer information
- 16: subunit layer information
- 50: device list display screen
- 51, 55, 57: device map display screen
- 52: safety controller status display screen
- 53: safety I/O unit status display screen
- 54: remote I/O device status display screen
- 56: location display screen
- 60, 61, 62, 63, 64, 65: message display screen
- 66, 68: list
- 67: filtering box
- 100: programmable terminal
- 102, 202: processor
- 104, 204: chipset
- 106, 206: main memory
- 108, 208: nonvolatile memory
- 109 HMI-: program
- 110,210: clock
- 112, 150: communication interface
- 114: camera
- 116: operation key
- 120: touchscreen
- 122: display
- 124: touch panel
- 200: PLC
- 220, 230: network controller
- 222, 232, 242: buffer memory
- 224, 234, 244: transfer control circuit
- 226, 236, 246: DMA control circuit
- 228, 238, 248: connector
- 240: internal bus controller
- 260: memory card interface
- 262: memory card
- 300: remoter I/O device
- 310 I/O: unit
- 400: safety controller
- 410: safety I/O unit

## Claims

1. An information processing apparatus that is connected to a control system including a first network configured to allow constant period communication, the first network being connected to a first node configured to manage the constant period communication and to one or more second nodes other than the first node, the apparatus comprising:
a first obtaining unit configured to obtain, from the first node, first status information indicating a communicating status of each of the second nodes in the first network;
a second obtaining unit configured to obtain second status information indicating an operating status of each of the second nodes;
a third obtaining unit configured to obtain third status information indicating an operating status of one of the second nodes that includes a device of a predetermined type; and
an output unit configured to output, for each of the second nodes, the first status information, the corresponding second status information, and the corresponding third status information in a manner arranged in line.

2. The information processing apparatus according to claim 1, wherein
the output unit changes a display mode of at least one of the first status information, the second status information, or the third status information depending on the corresponding status.

3. The information processing apparatus according to claim 1 or claim 2, wherein
in response to selection of the third status information, the output unit outputs more detailed information than previous output of the third status information about the corresponding selected device.

4. The information processing apparatus according to claim 3, wherein
when the selected device includes one or more input-output units and an arithmetic unit for transmitting and receiving intended data between the one or more input-output units and the arithmetic unit, the output unit outputs, as the detailed information, a list of statuses of the one or more input-output units managed by the arithmetic unit.

5. The information processing apparatus according to claim 4, wherein
in response to selection of one of the listed input-output units, the output unit outputs an input status or an output status of the selected input-output unit.

6. The information processing apparatus according to any one of claims 3 to 5, wherein
when the selected device includes one or more input-output units for collecting and outputting data to be used in another arithmetic unit through the first network, the output unit outputs an input status or an output status of each of the input-output units as the detailed information.

7. The information processing apparatus according to any one of claims 1 to 6, wherein
the output unit outputs the third status information together with information indicating the type of the corresponding device with an operating status indicated by the third status information.

8. The information processing apparatus according to any one of claims 1 to 7, wherein
one of the second nodes includes an input-output unit connected to a second network,
the information processing apparatus further comprises a fourth obtaining unit configured to obtain fourth status information indicating a status of the input-output unit connected to the second network, and
the output unit outputs the corresponding fourth status information, the first status information, the corresponding second status information, and the corresponding third status information in a manner arranged in line.

9. An information processing program executable by a computer that is connected to a control system including a first network configured to allow constant period communication, the first network being connected to a first node configured to manage the constant period communication and to one or more second nodes other than the first node, the information processing program enabling the computer to implement:
obtaining, from the first node, first status information indicating a communicating status of each of the second nodes in the first network;
obtaining second status information indicating an operating status of each of the second nodes;
obtaining third status information indicating an operating status of one of the second nodes that includes a device of a predetermined type; and
outputting, for each of the second nodes, the first status information, the corresponding second status information, and the corresponding third status information in a manner arranged in line.

10. An information processing method implemented by an apparatus that is connected to a control system including a first network configured to allow constant period communication, the first network being connected to a first node configured to manage the constant period communication and to one or more second nodes other than the first node, the information processing method comprising:
obtaining, from the first node, first status information indicating a communicating status of each of the second nodes in the first network;
obtaining second status information indicating an operating status of each of the second nodes;
obtaining third status information indicating an operating status of one of the second nodes that includes a device of a predetermined type; and
outputting, for each of the second nodes, the first status information, the corresponding second status information, and the corresponding third status information in a manner arranged in line.

11. An information processing apparatus that is connected to a control system including a first network configured to allow constant period communication, the first network being connected to a first node configured to manage the constant period communication and to one or more second nodes other than the first node, the apparatus comprising:
an obtaining unit configured to obtain first abnormality information indicating an abnormality caused in the first network and second abnormality information indicating an abnormality caused in each of the second nodes;
a first output unit configured to output, for each of the second nodes, a communicating status and an operating status of the second node in the first network; and
a second output unit configured to extract, in response to selection of the output communicating status of one of the second nodes, the abnormality caused in the selected second node from the first abnormality information and output information about the extracted abnormality, and in response to selection of the output operating status of one of the second nodes, extract and output the second abnormality information corresponding to the selected second node.

12. The information processing apparatus according to claim 11, wherein
the first output unit outputs the operating status of one of the second nodes that includes a device of a predetermined type, and
when the operating status of the device of the predetermined type is output, in response to a user operation, the second output unit extracts, from the second abnormality information, an abnormality caused in the device having the output operating status and in a device connected to the device, and outputs information about the extracted abnormality.

13. The information processing apparatus according to claim 12, wherein
the device of the predetermined type includes an arithmetic unit for transmitting and receiving intended data between one or more input-output units and the arithmetic unit.

14. The information processing apparatus according to claim 13, wherein
when an input status or an output status of the input-output units mounted on the arithmetic unit is output, in response to selection of one of the input-output units, the second output unit extracts, from the second abnormality information, an abnormality caused in the input-output units having the output statuses, and outputs information about the extracted abnormality.

15. The information processing apparatus according to any one of claims 11 to 14, wherein
the second output unit allows selective output of the first abnormality information in response to a user operation.

16. An information processing program executable by a computer that is connected to a control system including a first network configured to allow constant period communication, the first network being connected to a first node configured to manage the constant period communication and to one or more second nodes other than the first node, the information processing program enabling the computer to implement:
obtaining first abnormality information indicating an abnormality caused in the first network and second abnormality information indicating an abnormality caused in each of the second nodes;
outputting, for each of the second nodes, a communicating status and an operating status of the second node in the first network; and
extracting, in response to selection of the output communicating status of one of the second nodes, the abnormality caused in the selected second node from the first abnormality information and outputting information about the extracted abnormality, and in response to selection of the output operating status of one of the second nodes, extracting and outputting the second abnormality information corresponding to the selected second node.

17. An information processing method implemented by an apparatus that is connected to a control system including a first network configured to allow constant period communication, the first network being connected to a first node configured to manage the constant period communication and to one or more second nodes other than the first node, the information processing method comprising:
obtaining first abnormality information indicating an abnormality caused in the first network and second abnormality information indicating an abnormality caused in each of the second nodes;
outputting, for each of the second nodes, a communicating status and an operating status of the second node in the first network; and
extracting, in response to selection of the output communicating status of one of the second nodes, the abnormality caused in the selected second node from the first abnormality information and outputting information about the extracted abnormality, and in response to selection of the output operating status of one of the second nodes, extracting and outputting the second abnormality information corresponding to the selected second node.
